# EUROPEAN PATENT SPECIFICATION

(11) **EP 3 826 292 B1**
(45) Date of publication and mention of the grant of the patent: **16.10.2024**
(21) Application number: 19838874.6
(22) Date of filing: 16.07.2019
(51) Int. Cl.: H04N 5/262, H04N 23/45, H04N 23/57, H04N 23/67, H04N 23/80, H04N 25/131, H04N 25/13, H04N 25/704, H01L 27/146

(54) **MOBILE TERMINAL AND IMAGE CAPTURING METHOD**
MOBILES ENDGERÄT UND BILDAUFZEICHNUNGSVERFAHREN
TERMINAL MOBILE, ET PROCÉDÉ D'ENREGISTREMENT D'IMAGES

(30) Priority: 19.07.2018 CN 201810798027
(43) Date of publication of application: 26.05.2021
(73) Proprietor: Vivo Mobile Communication Co., Ltd., Dongguan, Guangdong 523860 (CN)
(72) Inventor: WANG, Danmei, Dongguan, Guangdong 523860 (CN); ZHOU, Huazhao, Dongguan, Guangdong 523860 (CN); ZHU, Panpan, Dongguan, Guangdong 523860 (CN)
(74) Representative: Winter, Brandl - Partnerschaft mbB
(86) International application number: PCT/CN2019/096126
(87) International publication number: WO 2020/015626

(56) References cited:
- WO-A2-2017/171412
- CN-A- 106 982 328
- CN-A- 107 040 724
- CN-A- 108 271 012
- CN-A- 108 900 772
- CN-U- 207 354 459
- US-A1- 2017 187 948
- US-A1- 2017 366 798
- ANONYMOUS: "Laser AF, PDAF, CDAF, DUAL PIXEL AF Explained: Which is Better? - Tech - Mi Community - Xiaomi", 5 April 2018 (2018-04-05), pages 1 - 8, XP055817787, Retrieved from the Internet <URL:https://c.mi.com/thread-904594-1-0.html> [retrieved on 20210624]

## Description

### TECHNICAL FIELD

The present disclosure relates to the field of image processing technology, and in particular, to a mobile terminal and an image photographing method.

### Related Art

Currently, an intelligent electronic product has gradually become a necessity in people's lives, and a photographing function is gradually developed as an important configuration of the electronic product. However, with promotion and popularization of the photographing function, people are not satisfied with the only photographing function of a camera in the current intelligent electronic product, and expect to achieve a diversified photographing effect, a diversified gameplay, and a diversified function.

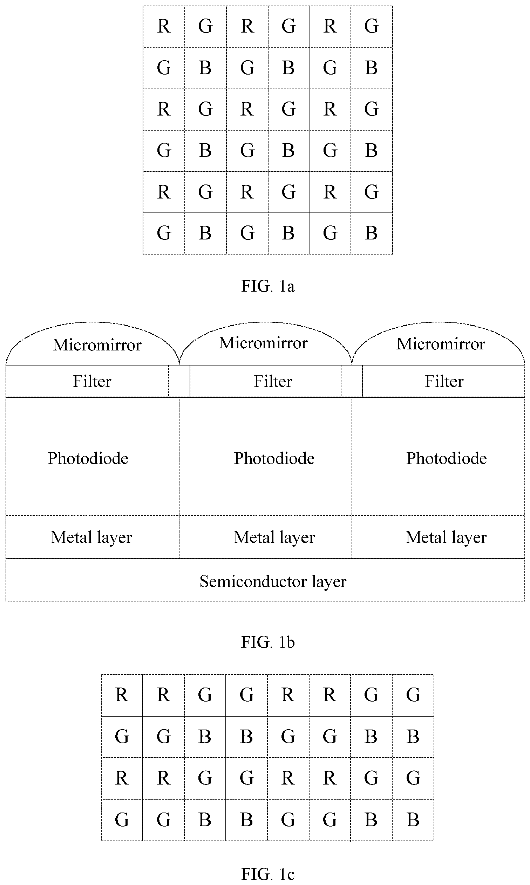

Currently, in a pixel array arrangement of an image sensor based on a complementary metal-oxide-semiconductor (Complementary Metal-Oxide-Semiconductor, CMOS), an R (red) G (green) B (blue) Bayer pixel array arrangement mode is most commonly used, as shown in FIG. 1a and FIG. 1b. However, in this arrangement manner, an object distance cannot be detected, and only natural light can be received. An image is photographed and recorded in normal light.

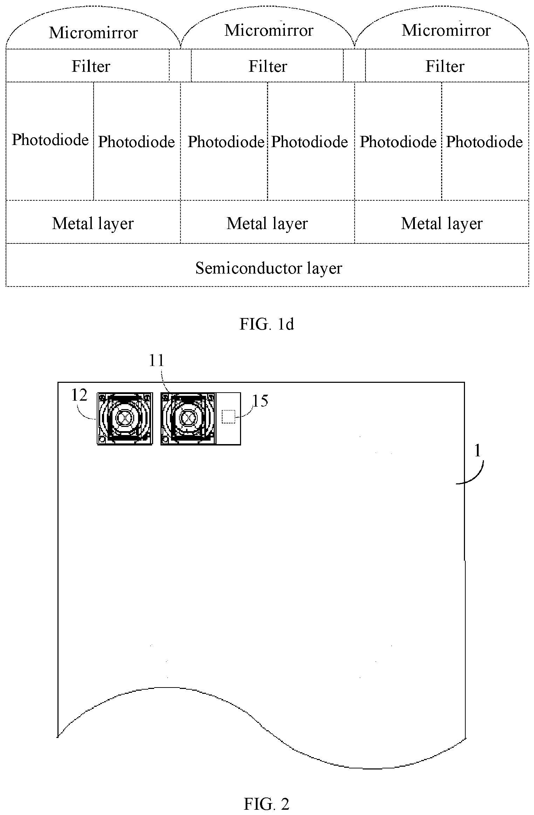

A pixel array arrangement mode of a full-pixel dual-core focus ( full-pixel dual-core focus, 2PD) technology is shown in FIG. 1c and FIG. 1d. In this arrangement manner, only natural light can be received for photographing and recording an image. However, in a phase detection auto focus (Phase Detection Auto Focus, PDAF) technical solution, an object distance can be detected, and a focus action can be performed more quickly.

A principle of A 2PD phase detection technology is as follows: It can be learned from FIG. 1c and FIG. 1d that some R, G, and B subpixels in a pixel array are split, and light energy obtained in different incident directions is different, so that a phase detection pair is formed between a left subpixel and a right subpixel. When brightness values of both the left subpixel and the right subpixel reach a relatively maximum peak value, an image is relatively clear in this case, that is, focusing is implemented, and then an object distance is obtained through calculation by using an algorithm, thereby implementing fast focusing.

US2017/0366798A1 provides an image detecting device, including a color image sensor configured to output color image data based on sensed visible light; a first infrared lighting source configured to provide first infrared rays; a second infrared lighting source configured to provide second infrared rays; a mono image sensor configured to sense a first infrared light or a second infrared light reflected from the subject and output infrared image data; and an image signal processor configured to, measure an illuminance value based on the color image data, measure a distance value of the subject based on a portion of the infrared image data corresponding to the first infrared light, and obtain an identification image of the subject based on the illuminance value, the distance value, and a portion of the infrared image data corresponding to the second infrared light.

US2017/0187948A1 provides an image sensor, including: a sensor array layer including normal sensor units and a pair of autofocus sensor units; color filter units on the sensor array layer to cover the normal sensor units; a pair of IR-pass filter units on the sensor array layer to respectively cover the pair of autofocus sensor units; a micro-lens layer including micro-lenses on the color filter units and the IR-pass filter units, where one of the pair of autofocus sensor units detects infrared light came from a first side, and the other of the pair of autofocus sensor units detects infrared light came from a second side opposite to the first side to perform a phase detection autofocus function.

"Laser AF, PDAF, CDAF, DUAL PIXEL AF Explained: Which is Better-Tech- Mi Community - Xiaomi" (https://c.mi.com/thread-904594-1-0.html) discusses pros and cons of laser AF, PDAF, CDAF, dual pixel AF.

CN 106982328 A provides a dual-core focusing image sensor, including a photosensitive unit array, a filtering unit array, and a micro lens array. The micro lens array includes a first micro lens and a second micro lens. One first micro lens covers one white filtering unit. One white filtering unit covers one focusing photosensitive unit. The focusing photosensitive unit includes N*N photosensitive pixels, each photosensitive pixel corresponding to a photodiode. The photodiode is fan-shaped. One second micro lens covers one dual-core focusing photosensitive pixel.

In view of the above, the object distance cannot be detected in the pixel array arrangement of the image sensor in the CMOS, and only the natural light can be received. Although the object distance can be detected in the pixel array arrangement of the 2PD technology, only natural light can be received. Therefore, in a pixel array arrangement mode of an image sensor in the related technology, a photographing scenario is limited, focusing is slow, and user photographing experience is affected.

### SUMMARY

Some embodiments of the present disclosure provide a mobile terminal and an image photographing method, to resolve problems in the related art that a photographing scenario is limited, focusing is slow, and user photographing experience is affected.

To resolve the foregoing problem, some embodiments of the present disclosure according to the present invention as claimed in the accompanying claims are implemented as follows:

According to a first aspect, some embodiments of the present disclosure provide a mobile terminal according to claim 1, including a first camera module and a second camera module adjacent to the first camera module, where the first camera module includes a first image sensor, and the second camera module includes a second image sensor.

A first pixel array corresponding to the first image sensor includes a preset quantity of first pixel units arranged in a first predetermined manner, and the first pixel unit includes a first pixel and a second pixel adjacent to the first pixel in location.

A second pixel array corresponding to the second image sensor includes a preset quantity of second pixel units arranged in a second predetermined manner, and the second pixel unit includes a first pixel.

The first pixel includes a red subpixel, a green subpixel, and a blue subpixel. The second pixel includes the green subpixel and an infrared subpixel, and at least one of the red subpixel and the blue subpixel. Both the first pixel and the second pixel are full-pixel dual-core focus pixels, and each of the first pixel and the second pixel includes four full-pixel dual-core focus subpixels.

According to a second aspect, some embodiments of the present disclosure provide an image photographing method according to claim 12,
applied to the foregoing mobile terminal. The method includes:
obtaining depth of field information by using a first camera module and a second camera module;
obtaining, according to the depth of field information, first image data collected by the first camera module and second image data collected by the second camera module, where the first image data and the second image data are same-frame data;
and generate a background blurred image through triangulation ranging according to the first image data and the second image data.

According to a third aspect, some embodiments of the present disclosure further provide an image photographing method, applied to the foregoing mobile terminal. The mobile terminal further includes an infrared emitting module disposed on a periphery of a first camera module, and the method includes:
emitting infrared light by using the infrared emitting module;
obtaining a distance between each infrared light reflection point on a to-be-photographed object and the first camera module according to infrared light reflected by the to-be-photographed object; and
obtaining stereoscopic information of the to-be-photographed object according to the distance between each infrared light reflection point on the to-be-photographed object and the first camera module

According to the technical solutions of the present disclosure, the first camera module is formed by using the first image sensor, and the second camera module is formed by using the second image sensor. After the two camera modules are combined, a dual camera is formed. In this combination manner, not only fast focusing can be ensured, but also distance detection between the mobile terminal and the to-be-photographed object can be performed by using infrared light, thereby improving an image imaging effect, implementing a stereoscopic photographing related application function and a background blurring function, ensuring function diversity of the mobile terminal, improving user experience, and meeting a user requirement.

### BRIEF DESCRIPTION OF DRAWINGS

To describe the technical solutions in some embodiments of the present disclosure more clearly, the following briefly describes the accompanying drawings required for describing some embodiments of the present disclosure. Apparently, the accompanying drawings in the following description show merely some embodiments of the present disclosure, and a person of ordinary skill in the art may still derive other drawings from these accompanying drawings without creative efforts.
FIG 1a is a schematic diagram of a conventional RGB arrangement in the related art;
FIG 1b is a sectional view of a conventional pixel;
FIG 1c shows an arrangement diagram of a 2PD pixel array;
FIG 1d is a sectional view of a 2PD pixel;
FIG 2 is a schematic diagram 1 of a mobile terminal according to some embodiments of the present disclosure;
FIG 3a is a schematic diagram of a first camera module according to some embodiments of the present disclosure;
FIG. 3b is a schematic diagram of a second camera module according to some embodiments of the present disclosure;
FIG 4a is a schematic diagram 1 of a first pixel unit according to some embodiments of the present disclosure;
FIG 4b is a schematic diagram 2 of a first pixel unit according to some embodiments of the present disclosure;
FIG 4c is a schematic diagram 3 of a first pixel unit according to some embodiments of the present disclosure;
FIG 4d is a schematic diagram 4 of a first pixel unit according to some embodiments of the present disclosure;
FIG 4e is a schematic diagram 5 of a first pixel unit according to some embodiments of the present disclosure;
FIG 5a is a schematic diagram 6 of a first pixel unit according to some embodiments of the present disclosure;
FIG 5b is a schematic diagram 7 of a first pixel unit according to some embodiments of the present disclosure;
FIG 5c is a schematic diagram 8 of a first pixel unit according to some embodiments of the present disclosure;
FIG 6 is a sectional view of a pixel according to some embodiments of the present disclosure;
FIG 7 is a schematic diagram 2 of a mobile terminal according to some embodiments of the present disclosure;
FIG 8 is a schematic diagram of connection between a first camera module and an image processor according to some embodiments of the present disclosure;
FIG 9 is a schematic diagram of connection between a second camera module and an image processor according to some embodiments of the present disclosure;
FIG 10 is a schematic diagram 1 of an image photographing method according to some embodiments of the present disclosure;
FIG 11 is a schematic diagram 2 of an image photographing method according to some embodiments of the present disclosure; and
FIG 12 is a schematic diagram of a hardware structure of a mobile terminal according to some embodiments of the present disclosure.

### DETAILED DESCRIPTION

The following clearly and completely describes the technical solutions in some embodiments of the present disclosure with reference to the accompanying drawings in some embodiments of the present disclosure. Apparently, the described embodiments are merely some but not all of the embodiments of the present disclosure.

Some embodiments of the present disclosure provide a mobile terminal. As shown in FIG 2, FIG 3a to FIG 3b, and FIG 4a to FIG 4e, a mobile terminal 1 includes a first camera module 11 and a second camera module 12 adjacent to the first camera module 11, the first camera module 11 includes a first image sensor 111, and the second camera module 12 includes a second image sensor 121.

A first pixel array corresponding to the first image sensor 111 includes a preset quantity of first pixel units arranged in a first predetermined manner, and the first pixel unit includes a first pixel and a second pixel adjacent to the first pixel in location.

A second pixel array corresponding to the second image sensor 121 includes a preset quantity of second pixel units arranged in a second predetermined manner, and the second pixel unit includes a first pixel.

The first pixel includes a red subpixel, a green subpixel, and a blue subpixel. The second pixel includes the green subpixel and an infrared subpixel, and at least one of the red subpixel and the blue subpixel. Both the first pixel and the second pixel are full-pixel dual-core focus pixels, and each of the first pixel and the second pixel includes four full-pixel dual-core focus subpixels.

The mobile terminal 1 provided in some embodiments of the present disclosure includes the first camera module 11 and the second camera module 12, the first camera module 11 includes the first image sensor 111 and the second camera module 12 includes the second image sensor 121. The first image sensor 111 corresponds to the first pixel array, and the second image sensor 121 corresponds to the second pixel array. Locations of the first camera module 11 and the second camera module 12 are adjacent.

The first pixel array includes the preset quantity of first pixel units, the preset quantity of first pixel units are arranged in the first predetermined manner, and the preset quantity of first pixel units include the first pixel and the second pixel. The second pixel array includes the preset quantity of second pixel units, and the preset quantity of second pixel units are arranged in the second predetermined manner. The preset quantity of second pixel units include the first pixel.

Subpixels in the first pixel and the second pixel are different. The first pixel includes a red subpixel (R), a green subpixel (G), and a blue subpixel (B). The second pixel includes the green subpixel and an infrared subpixel (IR), and at least one of the red subpixel and the blue subpixel. The infrared subpixel is set in the second pixel, so that image photographing can be performed when infrared light is received, thereby implementing imaging in a dark state and ensuring user photographing experience.

In addition, both the first pixel and the second pixel in some embodiments of the present disclosure are full-pixel dual-core focus (2PD) pixels. An object distance may be detected by using the 2PD pixel, and a focusing action is more quickly completed. Both the first pixel and the second pixel herein are 2PD pixels, that is, subpixels in both the first pixel and the second pixel are 2PD subpixels. The first camera module 11 and the second camera module 12 can quickly complete a focusing process by using the 2PD pixel.

The red subpixel, the green subpixel, and the blue subpixel in the first pixel are arranged in a specific manner. The first pixel includes four full-pixel dual-core focus subpixels, and specifically includes one red subpixel, one blue subpixel, and two green subpixels. Herein, for ease of distinguishing, the two green subpixels are respectively referred to as a first green subpixel and a second green subpixel, where the first green subpixel is the same as the second green subpixel. The red subpixel is adjacent to the first green subpixel, the second green subpixel is located below the red subpixel, the blue subpixel is located below the first green subpixel, and the second green subpixel is adjacent to the blue subpixel.

The second pixel includes four full-pixel dual-core focus subpixels, and specifically includes the green subpixel and the infrared subpixel, and at least one of the red subpixel and the blue subpixel. That is, the second pixel may include three subpixels or four subpixels. When the second pixel includes three subpixels, the second pixel may include the red subpixel, the green subpixel, and the infrared subpixel, and a quantity of green subpixels is two in this case; or may include the blue subpixel, the green subpixel, and the infrared subpixel, and a quantity of green subpixels is two. When the second pixel includes four subpixels, the second pixel may include the red subpixel, the blue subpixel, the green subpixel, and the infrared subpixel.

In some embodiments of the present disclosure, an RGB pixel array arrangement manner is improved to change the RGB pixel array arrangement manner to an RGB-IR (infrared) pixel array arrangement manner, so that image photographing can be performed when infrared light is received, thereby implementing imaging in a dark state and ensuring user photographing experience. In addition, setting of the 2PD pixel can implement fast focusing.

In addition, the image sensor in some embodiments of the present disclosure may cooperate with an infrared emitting module to implement a stereoscopic photographing related application function, and a background blurring function may be implemented by using the two camera modules according to a triangulation ranging principle, thereby ensuring user photographing experience and enhancing functionality of the mobile terminal.

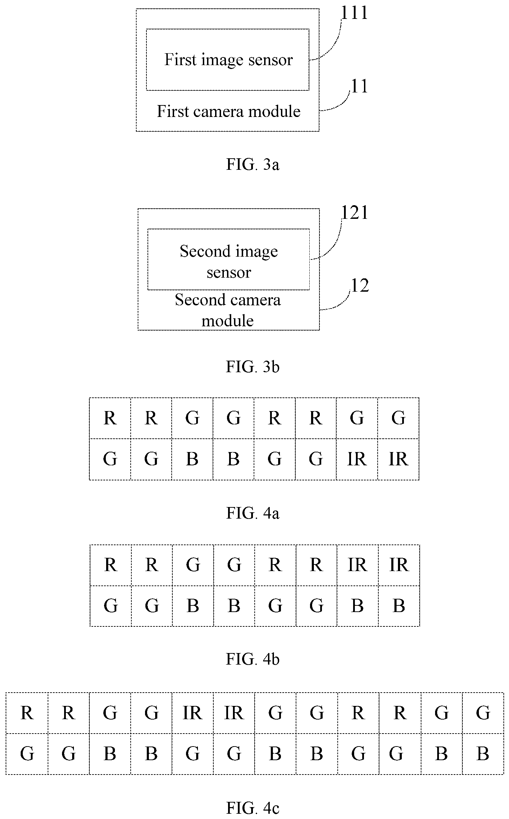

In some embodiments of the present disclosure, as shown in FIG 4a to FIG 4e, a location of the infrared subpixel in the second pixel is the same as a location of the red subpixel, the green subpixel, or the blue subpixel in the first pixel; or
a location of the infrared subpixel in the second pixel is the same as a location of a first combined subpixel in the first pixel, or the same as a location of a second combined subpixel in the first pixel.

The first combined subpixel is a combination of 1/2 red subpixel and 1/2 green subpixel adjacent in location, and the second combined subpixel is a combination of 1/2 green subpixel and 1/2 blue subpixel adjacent in location.

When the location of the infrared subpixel in the second pixel is the same as the location of the red subpixel in the first pixel, the second pixel includes one blue subpixel, two green subpixels, and one infrared subpixel. In this case, on the basis of the first pixel, the red subpixel is replaced with the infrared subpixel. When the location of the infrared subpixel in the second pixel is the same as the location of the blue subpixel in the first pixel, the second pixel includes one red subpixel, two green subpixels, and one infrared subpixel. In this case, on the basis of the first pixel, the blue subpixel is replaced with the infrared subpixel. When the location of the infrared subpixel in the second pixel is the same as the location of the green subpixel in the first pixel, the second pixel includes one red subpixel, two green subpixels, one blue subpixel, and one infrared subpixel. In this case, on the basis of the first pixel, the green subpixel is replaced with the infrared subpixel.

When the location of the infrared subpixel in the second pixel is the same as the location of the first combined subpixel in the first pixel, the second pixel includes the red subpixel, the green subpixel, the blue subpixel, and the infrared subpixel. In this case, on the basis of the first pixel, 1/2 red subpixel and 1/2 green subpixel that are adjacent to the 2PD subpixel in location may be used as the infrared subpixel.

When the location of the infrared subpixel in the second pixel is the same as the location of the second combined subpixel in the first pixel, the second pixel includes the red subpixel, the green subpixel, the blue subpixel, and the infrared subpixel. In this case, on the basis of the first pixel, 1/2 blue subpixel and 1/2 green subpixel that are adjacent to the 2PD subpixel in location may be used as the infrared subpixel.

On the basis of the foregoing embodiment, the first pixel unit includes one second pixel and at least one first pixel.

The first pixel unit includes one second pixel and at least one first pixel, and there are at least two pixels in the first pixel unit. When there are two pixels in the first pixel unit, one first pixel and one second pixel are included, and a capturing density of the infrared subpixel in the first pixel unit is 1/8 in this case. For example, as shown in FIG 4a, the first pixel unit includes one first pixel and one second pixel, and the second pixel includes one red subpixel, two green subpixels, and one infrared subpixel. Alternatively, as shown in FIG 4b, the first pixel unit includes one first pixel and one second pixel, and the second pixel includes one red subpixel, one green subpixel, one blue subpixel, and one infrared subpixel. In the foregoing two cases, a proportion of the infrared subpixel in the first pixel unit is 1/8, that is, a capturing density of the infrared subpixel is 1/8.

When there are three pixels in the first pixel unit, two first pixels and one second pixel are included, and a density of the infrared subpixel in the first pixel unit is 1/12 in this case. For example, as shown in FIG 4c, the first pixel unit includes two first pixels and one second pixel, and the second pixel includes one blue subpixel, two green subpixels, and one infrared subpixel. A proportion of the infrared subpixel in the first pixel unit is 1/12, that is, a capturing density of the infrared subpixel is 1/12.

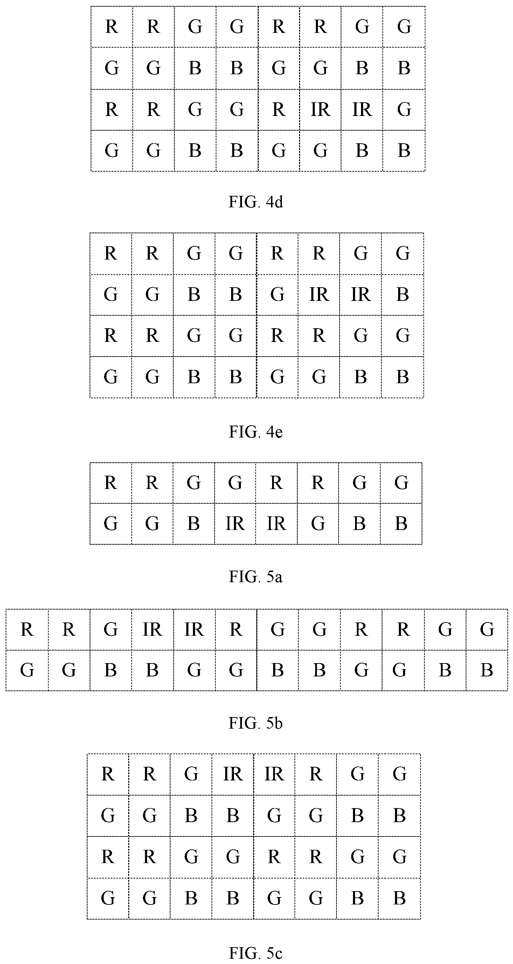

When there are four pixels in the first pixel unit, three first pixels and one second pixel are included, and a density of the infrared subpixel in the first pixel unit is 1/16 in this case. For example, as shown in FIG 4d, the first pixel unit includes three first pixels and one second pixel, and the second pixel includes a blue subpixel, a green subpixel, a red subpixel, and an infrared subpixel. In this case, on the basis of the first pixel, 1/2 red subpixel and 1/2 green subpixel of the 2PD subpixel may be used as the infrared subpixel. Alternatively, as shown in FIG 4e, the first pixel unit includes three first pixels and one second pixel, and the second pixel includes a blue subpixel, a green subpixel, a red subpixel, and an infrared subpixel. On the basis of the first pixel, 1/2 blue subpixel and 1/2 green subpixel of the 2PD subpixel may be used as the infrared subpixel. In the foregoing two cases, a proportion of the infrared subpixel in the first pixel unit is 1/16, that is, a capturing density of the infrared subpixel is 1/16.

The foregoing several capturing manners of the infrared subpixel corresponding to FIG 4a to FIG 4e are merely used as examples for description, or there may be another capturing g manner. A plurality of corresponding implementations are not described one by one herein. A capturing location of the infrared subpixel in the first pixel unit (a location of the second pixel) is not limited in some embodiments of this disclosure. A density of the infrared subpixel in the first pixel unit is l/4n, n is an integer greater than or equal to 2, and a size of the first pixel array to which the infrared subpixel is applicable is not limited.

In some embodiments of the present disclosure, as shown in FIG 5a to FIG 5c, a location of 1/2 infrared subpixel in the second pixel is the same as a location of 1/2 red subpixel, 1/2 green subpixel, or 1/2 blue subpixel in the first pixel, and 1/2 infrared subpixel in two adjacent second pixels constitutes the infrared subpixel.

The second pixel may include only 1/2 infrared subpixel, and one complete infrared subpixel may be obtained by combining two second pixels. When the second pixel includes the 1/2 infrared subpixel, the location of the 1/2 infrared subpixel in the second pixel may be the same as the location of the 1/2 red subpixel in the first pixel, or may be the same as the location of the 1/2 green subpixel in the first pixel, or may be the same as the location of the 1/2 blue subpixel in the first pixel.

When a location of 1/2 infrared subpixel in one second pixel is the same as the location of the 1/2 red subpixel in the first pixel, a location of 1/2 infrared subpixel in another second pixel is the same as the location of the 1/2 green subpixel in the first pixel. When a location of 1/2 infrared subpixel in one second pixel is the same as the location of the 1/2 green subpixel in the first pixel, a location of 1/2 infrared subpixel in another second pixel is the same as the location of the 1/2 blue subpixel or the 1/2 red subpixel in the first pixel.

On the basis of the foregoing embodiment, in the first pixel unit, a number of second pixels is two, and a number of first pixels is greater than or equal to zero.

There are at least two pixels in the first pixel unit, and the first pixel unit includes two second pixels and a first pixel whose quantity is greater than or equal to zero. When there are two pixels in the first pixel unit, two second pixels are included, and a capturing density of the infrared subpixel in the first pixel unit is 1/8 in this case. For example, as shown in FIG 5a, the first pixel unit includes two second pixels, where each second pixel includes a red subpixel, a green subpixel, a blue subpixel, and 1/2 infrared subpixel. In this case, a location of 1/2 infrared subpixel in one second pixel is the same as the location of the 1/2 green subpixel in the first pixel, and a location of 1/2 infrared subpixel in another second pixel is the same as the location of the 1/2 blue subpixel in the first pixel. A proportion of the infrared subpixel in the first pixel unit is 1/8, that is, a capturing density of the infrared subpixel is 1/8.

When there are three pixels in the first pixel unit, two second pixels and one first pixel are included, and a capturing density of the infrared subpixel in the first pixel unit is 1/12 in this case. For example, as shown in FIG 5b, the first pixel unit includes two second pixels and one first pixel, and each second pixel includes a red subpixel, a green subpixel, a blue subpixel, and 1/2 infrared subpixel. In this case, a location of 1/2 infrared subpixel in one second pixel is the same as the location of the 1/2 red subpixel in the first pixel, and a location of 1/2 infrared subpixel in another second pixel is the same as the location of the 1/2 green subpixel in the first pixel. A proportion of the infrared subpixel in the first pixel unit is 1/12, that is, a capturing density of the infrared subpixel is 1/12.

When there are four pixels in the first pixel unit, two second pixels and two first pixels are included, and a capturing density of the infrared subpixel in the first pixel unit is 1/16 in this case. For example, as shown in FIG 5c, the first pixel unit includes two second pixels and two first pixels, and each second pixel includes a red subpixel, a green subpixel, a blue subpixel, and 1/2 infrared subpixel. In this case, a location of 1/2 infrared subpixel in one second pixel is the same as the location of the 1/2 green subpixel in the first pixel, and a location of 1/2 infrared subpixel in another second pixel is the same as the location of the 1/2 red subpixel in the first pixel. A proportion of the infrared subpixel in the first pixel unit is 1/16, that is, a capturing density of the infrared subpixel is 1/16.

The first pixel array may be formed when a 1/8-density RGB+IR pixel unit, a 1/12-density RGB+IR pixel unit, or a 1/16-density RGB+IR pixel unit is used as a pixel unit array, and the pixel unit array is then periodically arranged. Certainly, the first pixel array may be in another form, and is not enumerated herein.

The foregoing FIG 5a to FIG 5c are merely several corresponding implementations, and may be modified on this basis. Details are not described herein. A density of the infrared subpixel in the first pixel unit is l/4n, n is an integer greater than or equal to 2, and a size of the first pixel array to which the infrared subpixel is applicable is not limited.

In some embodiments of the present disclosure, the red subpixel includes a semiconductor layer, a metal layer, a photodiode, a red filter, and a micromirror stacked in sequence; the green subpixel includes a semiconductor layer, a metal layer, a photodiode, a green filter, and a micromirror stacked in sequence; the blue subpixel includes a semiconductor layer, a metal layer, a photodiode, a blue filter, and a micromirror stacked in sequence; and the infrared subpixel includes a semiconductor layer, a metal layer, a photodiode, an infrared filter, and a micromirror stacked in sequence.

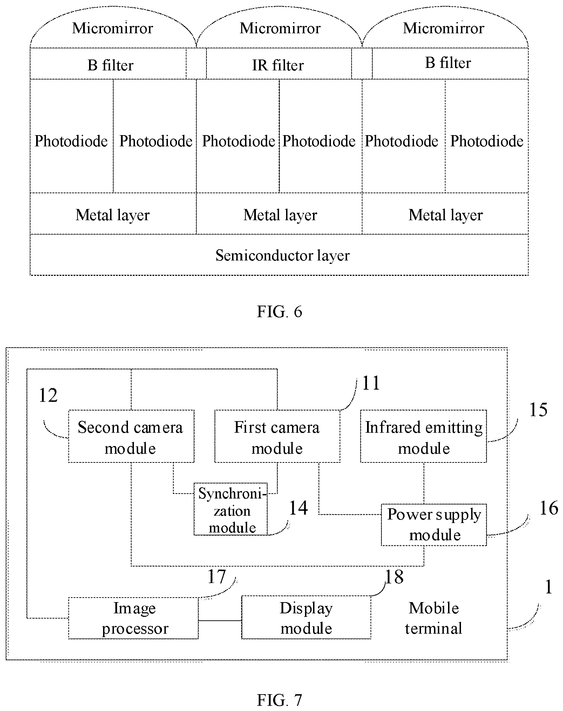

The semiconductor layer, the metal layer, the photodiode, the red filter, and the micromirror that are included in the red subpixel are arranged in sequence from bottom to top. The semiconductor layer, the metal layer, the photodiode, the green filter, and the micromirror that are included in the corresponding green subpixel are arranged in sequence from bottom to top. The semiconductor layer, the metal layer, the photodiode, the blue filter, and the micromirror that are included in the blue subpixel are arranged in sequence from bottom to top. The semiconductor layer, the metal layer, the photodiode, the infrared filter, and the micromirror that are included in the infrared subpixel are arranged in sequence from bottom to top. The semiconductor layer herein may be a silicon substrate, but is not limited thereto. For structures of red, green, blue, and infrared subpixels, refer to FIG 6. Although only blue and infrared subpixels are shown in FIG 6, structures of red and green subpixels may be learned on the basis of this. The blue filter may be replaced with the red or green filter to obtain the structure of the red subpixel or the green subpixel.

The red, green, and blue subpixels are used to obtain color information of a pixel of a synthesized image, and block entering of infrared light. For example, only visible light with a wavelength of 380 nm to 700 nm can be entered, and a full-color and lifelike image can be directly generated at high illuminance. An infrared wavelength is 750 nm to 1100 nm, and an infrared filtering area may be used to pass an infrared band, to improve an imaging effect in a dark state and implement an infrared ranging function.

It can be seen from the foregoing description that an RGB subpixel is a light receiving element corresponding to wavelength light of each RGB color, and an IR subpixel is a light receiving element corresponding to infrared light.

In some embodiments of the present disclosure, both the first image sensor and the second image sensor are complementary metal-oxide-semiconductor CMOS image sensors, charge coupled device CCD image sensors, or quantum thin film image sensors.

In the RGB-IR pixel array arrangement manner in the present disclosure, a type of an applicable image sensor is not limited, and the image sensor may be an image sensor based on a CMOS, an image sensor based on a charge coupled device (Charge Coupled Device, CCD), or an image sensor based on a quantum thin film, and certainly may be an image sensor of another type. In addition, the image sensor in some embodiments of the present disclosure may be applicable to any electronic product including a camera module.

In some embodiments of the present disclosure, as shown in FIG 2 and FIG 7, the first camera module 11 and the second camera module 12 are connected through a synchronization module 14, and the mobile terminal 1 further includes: an infrared emitting module 15 disposed on a periphery of the first camera module 11; a power supply module 16 connected to the first camera module 11, the second camera module 12, and the infrared emitting module 15; and an image processor 17 connected to the first camera module 11 and the second camera module 12, where both the image processor 17 and the power supply module 16 are integrated into a mainboard of the mobile terminal, and the infrared emitting module 15 is connected to the mainboard of the mobile terminal; and a display module 18 connected to the image processor 17.

The synchronization module 14 is connected between the first camera module 11 and the second camera module 12. The synchronization module 14 is disposed, so that the mobile terminal 1 can be controlled to implement frame synchronization data output between the first camera module 11 and the second camera module 12.

The infrared emitting module 15 is disposed on the periphery of the first camera module 11, where the first camera module 11, the second camera module 12, and the infrared emitting module 15 are all connected to the power supply module 16, and are configured to work according to power provided by the power supply module 16.

The first camera module 11 and the second camera module 12 are connected to the image processor 17 at the same time, and are connected to the display module 18 by using the image processor 17. After photoelectric conversion is performed on the first camera module 11 and the second camera module 12 through light focusing, data may be transmitted to the image processor 17. The image processor 17 presents the data in an image form on the display module 18 after processing. The infrared emitting module 15 is connected to the mainboard of the mobile terminal. Therefore, the mobile terminal may obtain a moment at which the infrared emitting module 15 emits infrared light. Because the image processor 17 is integrated into the mainboard, the mobile terminal may obtain a moment at which the first camera module 11 receives infrared light.

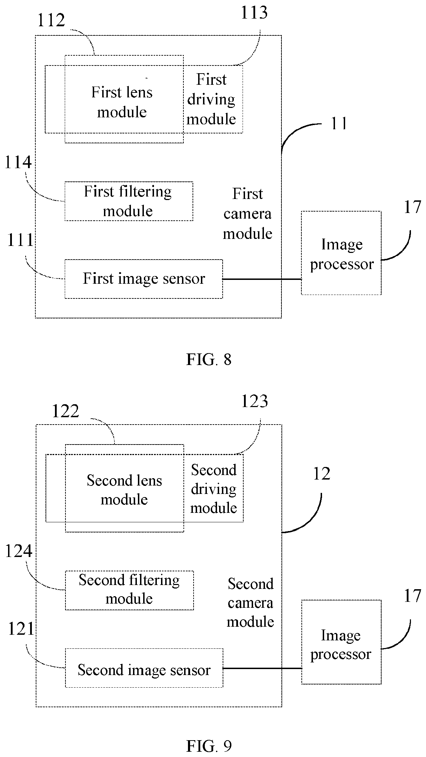

As shown in FIG 2 and FIG 8, the first camera module 11 further includes a first lens module 112; a first driving module 113 configured to drive the first lens module 112 to move; a first filtering module 114 disposed between the first lens module 112 and the first image sensor 111, where the first filtering module 114 can pass through an optical wavelength of 380 nm to 1100 nm.

The first lens module 112 is configured to focus light, the first lens module 112 is connected to the first driving module 113, and the first driving module 113 is configured to adjust a location of the first lens module 112 as the to-be-photographed object approaches.

The first filtering module 114 is disposed between the first lens module 112 and the first image sensor 111, where light is focused by the first lens module 112, and may be focused on a pixel array of the first image sensor 111 after passing through the first filtering module 114. The first image sensor 111 is connected to the image processor 17.

The first filtering module 114 in some embodiments of the present disclosure is a dual-pass filtering module that both natural light and infrared light can pass. In this case, after light is focused by the first lens module 112, filtering may be performed by the first filtering module 114, where the first filtering module 114 may be used for passing of natural light and infrared light, to ensure an imaging effect.

The infrared emitting module 15 may be disposed on the periphery of the first lens module 112. The infrared emitting module 15 emits the infrared light, and the infrared light is reflected after encountering an obstacle. After the reflected infrared light is captured, photoelectric conversion is performed on the infrared subpixel, to obtain a time difference between emission of the infrared light and reception of the infrared light. Because a propagation speed of light is fixed, a distance from the obstacle to the mobile terminal may be calculated, and a distance from each minimum unit on the obstacle to the mobile terminal may be finally obtained, to implement a stereoscopic imaging recording function of the first camera module. Certainly, the distance between each infrared light reflection point on the obstacle and the mobile terminal may be alternatively obtained in a manner of obtaining a phase difference of the infrared light. For details, refer to a time of flight (Time of Flight, TOF) technology. Details are not described herein.

As shown in FIG 2 and FIG 9, the second camera module 12 further includes a second lens module 122; a second driving module 123 configured to drive the second lens module 122 to move; a second filtering module 124 disposed between the second lens module 122 and the second image sensor 121, where the second filtering module 124 can pass through an optical wavelength of 380 nm to 700 nm.

The second lens module 122 is also configured to focus light, the second lens module 122 is connected to the second driving module 123, and the second driving module 123 is configured to adjust a location of the second lens module 122 as the to-be-photographed object approaches.

The second filtering module 124 is disposed between the second lens module 122 and the second image sensor 121, where light is focused by the second lens module 122, and may be focused on a pixel array of the second image sensor 121 after passing through the second filtering module 124. The second image sensor 121 is connected to the image processor 17.

The second filtering module 124 in some embodiments of the present disclosure is used for passing of natural light. In this case, after light is focused by the second lens module 122, filtering may be performed by using the second filtering module 124.

After the locations of the first lens module 112 and the second lens module 122 are adjusted, a phase difference may be obtained by using the 2PD pixel in the first image sensor 111 and the second image sensor 121, to obtain a distance between an object and an imaging surface, thereby implementing fast focusing.

According to the mobile terminal provided in some embodiments of the present disclosure, the first camera module is formed by using the first image sensor, and the second camera module is formed by using the second image sensor. The two camera modules are combined to form a dual camera. In this combination manner, not only fast focusing can be ensured, but also distance detection between the mobile terminal and the to-be-photographed object can be performed by using infrared light, thereby improving an image imaging effect, implementing a stereoscopic photographing related application function and a background blurring function, ensuring function diversity of the mobile terminal, improving user experience, and meeting a user requirement.

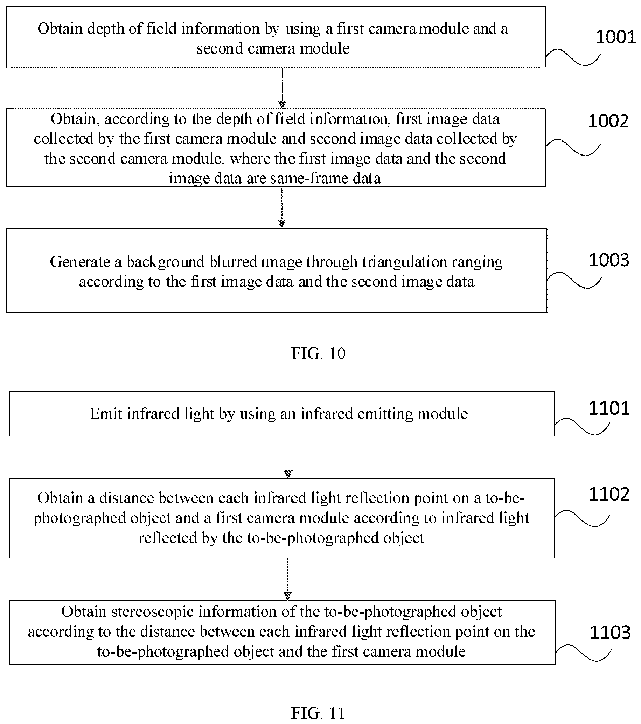

Some embodiments of the present disclosure further provide an image photographing method, applied to the above mobile terminal. As shown in FIG 10, the method includes the following steps.

Step 1001: Obtain depth of field information by using a first camera module and a second camera module.

In some embodiments of the present disclosure, the depth of field information may be determined by using the first camera module and the second camera module, that is, a range of a distance between a front location and a back location of a to-be-photographed object determined through imaging of a clear image is obtained.

Step 1002: Obtain, according to the depth of field information, first image data collected by the first camera module and second image data collected by the second camera module, where the first image data and the second image data are same-frame data.

After the depth of field information is determined, the first image data and the second image data of a same frame may be obtained according to the depth of field information. After the first image data and the second image data are obtained, step 1003 may be performed.

Step 1003: Generate a background blurred image through triangulation ranging according to the first image data and the second image data.

After the first image data and the second image data are obtained, because a distance between the two camera modules is known, data processing may be performed according to the same-frame data output by the two camera modules and in combination with a triangulation ranging principle, to obtain the background blurred image.

In the image photographing method in some embodiments of the present disclosure, the first camera module may be formed by using the first image sensor, and the second camera module may be formed by using the second image sensor. The two camera modules are combined to form a dual camera, and synchronization of data output by the two camera modules is ensured. In this combination manner, a background blurring function can be implemented, function diversity of the mobile terminal is ensured, user experience is improved, and a user requirement is met.

Some embodiments of the present disclosure further provide an image photographing method, applied to the above mobile terminal. The mobile terminal includes an infrared emitting module disposed on a periphery of a first camera module. As shown in FIG 11, the method includes the following steps.

Step 1101: Emit infrared light by using the infrared emitting module.

The infrared emitting module on the mobile terminal may emit infrared light. After encountering a to-be-photographed object, the infrared light is reflected, and the reflected infrared light is received by the first camera module of the mobile terminal. A first image sensor of the first camera module forms an RGB-IR pixel array. Therefore, photoelectric conversion may be performed by using an infrared subpixel.

Step 1102: Obtain a distance between each infrared light reflection point on a to-be-photographed object and the first camera module according to infrared light reflected by the to-be-photographed object.

When a distance between the to-be-photographed object and the first camera module is obtained, a distance between the to-be-photographed object and an imaging surface is actually obtained. After the first camera module captures the reflected infrared light, photoelectric conversion is performed by using the infrared subpixel to obtain a time difference between emission of the infrared light and reception of the infrared ray. Because a propagation speed of light is fixed, a distance between an obstacle and the first camera module may be calculated according to 1/2 of a product of the time difference and the propagation speed. Time at which the first camera module receives infrared light reflected by each infrared light reflection point is different. Therefore, a distance may be correspondingly calculated for each infrared light reflection point, so that the distance between each infrared light reflection point and the first camera module can be obtained. Certainly, the distance between each infrared light reflection point and the first camera module may be obtained by obtaining a phase difference of the infrared light. For details, refer to a time of flight (Time of Flight, TOF) technology. Details are not described herein.

Step 1103: Obtain stereoscopic information of the to-be-photographed object according to the distance between each infrared light reflection point on the to-be-photographed object and the first camera module.

When a distance between the to-be-photographed object and the mobile terminal is obtained, a distance between each minimum unit on the to-be-photographed object and the first camera module is specifically obtained, and then a procedure of photographing the to-be-photographed object is performed, to implement a stereo imaging recording function of the first camera module.

In the image photographing method in some embodiments of the present disclosure, the first camera module may be formed by using the first image sensor, and the infrared emitting module detects the distance between the first camera module and the to-be-photographed object by using the infrared light, thereby improving an image imaging effect and implementing a stereoscopic photographing related application function.

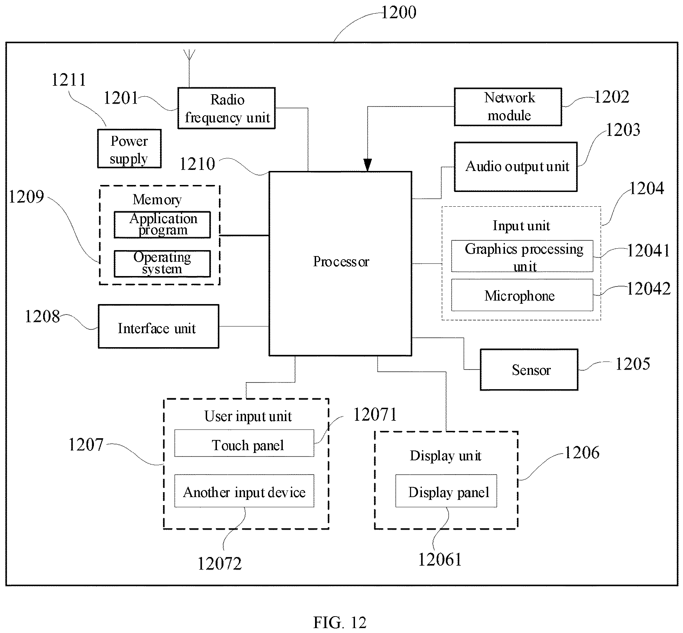

FIG 12 is a schematic diagram of a hardware structure of a mobile terminal according to the embodiments of the present disclosure. The mobile terminal 1200 includes but is not limited to components such as a radio frequency unit 1201, a network module 1202, an audio output unit 1203, an input unit 1204, a sensor 1205, a display unit 1206, a user input unit 1207, an interface unit 1208, a memory 1209, a processor 1210, and a power supply 1211.

The mobile terminal 1200 further includes a first camera module and a second camera module adjacent to the first camera module, the first camera module includes a first image sensor, and the second camera module includes a second image sensor.

A first pixel array corresponding to the first image sensor includes a preset quantity of first pixel units arranged in a first predetermined manner, and the first pixel unit includes a first pixel and a second pixel adjacent to the first pixel in location.

A second pixel array corresponding to the second image sensor includes a preset quantity of second pixel units arranged in a second predetermined manner, and the second pixel unit includes a first pixel.

The first pixel includes a red subpixel, a green subpixel, and a blue subpixel. The second pixel includes the green subpixel and an infrared subpixel, and at least one of the red subpixel and the blue subpixel. Both the first pixel and the second pixel are full-pixel dual-core focus pixels, and each of the first pixel and the second pixel includes four full-pixel dual-core focus subpixels.

A location of the infrared subpixel in the second pixel is the same as a location of the red subpixel, the green subpixel, or the blue subpixel in the first pixel; or
a location of the infrared subpixel in the second pixel is the same as a location of a first combined subpixel in the first pixel, or the same as a location of a second combined subpixel in the first pixel.

The first combined subpixel is a combination of 1/2 red subpixel and 1/2 green subpixel adjacent in location, and the second combined subpixel is a combination of 1/2 green subpixel and 1/2 blue subpixel adjacent in location.

The first pixel unit includes one second pixel and at least one first pixel.

A location of 1/2 infrared subpixel in the second pixel is the same as a location of 1/2 red subpixel, 1/2 green subpixel, or 1/2 blue subpixel in the first pixel, and 1/2 infrared subpixel in two adjacent second pixels constitutes the infrared subpixel.

In the first pixel unit, a quantity of second pixels is two, and a quantity of first pixels is greater than or equal to zero.

The red subpixel includes a semiconductor layer, a metal layer, a photodiode, a red filter, and a micromirror stacked in sequence; the green subpixel includes a semiconductor layer, a metal layer, a photodiode, a green filter, and a micromirror stacked in sequence; the blue subpixel includes a semiconductor layer, a metal layer, a photodiode, a blue filter, and a micromirror stacked in sequence; and the infrared subpixel includes a semiconductor layer, a metal layer, a photodiode, an infrared filter, and a micromirror stacked in sequence.

The first camera module and the second camera module are connected through a synchronization module.

The mobile terminal further includes:
an infrared emitting module disposed on a periphery of the first camera module;
a power supply module connected to the first camera module, the second camera module, and the infrared emitting module;
an image processor connected to the first camera module and the second camera module, where both the image processor and the power supply module are integrated into a mainboard of the mobile terminal, and the infrared emitting module is connected to the mainboard of the mobile terminal; and
a display module connected to the image processor.

The first camera module further includes:
a first lens module;
a first driving module configured to drive the first lens module to move; and
a first filtering module disposed between the first lens module and the first image sensor, where the first filtering module can pass through an optical wavelength of 380 nm to 1100 nm.

The second camera module further includes:
a second lens module;
a second driving module configured to drive the second lens module to move; and
a second filtering module disposed between the second lens module and the second image sensor, where the second filtering module can pass through an optical wavelength of 380 nm to 700 nm.

Both the first image sensor and the second image sensor are complementary metal-oxide-semiconductor CMOS image sensors, charge coupled device CCD image sensors, or quantum thin film image sensors.

A person skilled in the art may understand that the structure of the mobile terminal shown in FIG 12 constitutes no limitation on the mobile terminal, and the mobile terminal may include more or fewer parts than those shown in the figure, or combine some parts, or have a different part arrangement. In some embodiments of the present disclosure, the mobile terminal includes but is not limited to a mobile phone, a tablet computer, a laptop computer, a palmtop computer, an in-vehicle terminal, a wearable device, a pedometer, and the like.

The processor 1210 is configured to: obtain depth of field information by using a first camera and the second camera module;
obtain, according to the depth of field information, first image data collected by the first camera module and second image data collected by the second camera module, where the first image data and the second image data are same-frame data; and generate a background blurred image through triangulation ranging according to the first image data and the second image data.

The processor 1210 is further configured to: emit infrared light by using the infrared emitting module; obtain distance between each infrared light reflection point on a to-be-photographed object and the first camera module according to infrared light reflected by the to-be-photographed object; and obtain stereoscopic information of the to-be-photographed object according to the distance between each infrared light reflection point on the to-be-photographed object and the first camera module.

In this way, the first camera module is formed by using the first image sensor, and the second camera module is formed by using the second image sensor. After the two camera modules are combined, a dual camera is formed, and synchronization of data output between the two camera modules is implemented by using the synchronization module. In this combination manner, not only fast focusing can be ensured, but also distance detection between the mobile terminal and the to-be-photographed object can be performed by using infrared light, thereby improving an image imaging effect, implementing a stereoscopic photographing related application function and a background blurring function, ensuring function diversity of the mobile terminal, improving user experience, and meeting a user requirement.

It should be understood that, in some embodiments of the present disclosure, the radio frequency unit 1201 may be configured to receive and send information or receive and send a signal in a call process. Specifically, after receiving downlink data from a base station, the radio frequency unit sends the downlink data to the processor 1210 for processing. In addition, the radio frequency unit sends uplink data to the base station. Usually, the radio frequency unit 1201 includes but is not limited to an antenna, at least one amplifier, a transceiver, a coupler, a low noise amplifier, a duplexer, and the like. In addition, the radio frequency unit 1201 may communicate with a network and another device through a wireless communication system.

The mobile terminal provides wireless broadband Internet access for a user by using the network module 1202, for example, helping the user send and receive an email, browsing a web page, and accessing streaming media.

The audio output unit 1203 may convert audio data received by the radio frequency unit 1201 or the network module 1202 or stored in the memory 1209 into an audio signal and output the audio signal as a sound. In addition, the audio output unit 1203 may further provide audio output (for example, a call signal received voice, or a message received voice) related to a specific function executed by the mobile terminal 1200. The audio output unit 1203 includes a speaker, a buzzer, a receiver, and the like.

The input unit 1204 is configured to receive an audio signal or a video signal. The input unit 1204 may include a graphics processing unit (Graphics Processing Unit, GPU) 12041 and a microphone 12042. The graphics processing unit 12041 processes image data of a still image or a video that is obtained by an image photographing apparatus (for example, a camera) in a video photographing mode or an image photographing mode. A processed image frame may be displayed on the display unit 1206, and the display unit herein is the foregoing display module. The image frame processed by the graphics processing unit 12041 may be stored in the memory 1209 (or another storage medium) or sent by using the radio frequency unit 1201 or the network module 1202. The graphics processing unit 12041 is the foregoing image data processing module. The microphone 12042 may receive a sound and can process such sound into audio data. The processed audio data may be converted, in a call mode, into a format that can be sent by using the radio frequency unit 1201 to a mobile communication base station, and the format is output.

The mobile terminal 1200 further includes at least one sensor 1205 such as an optical sensor, a motion sensor, or another sensor. Specifically, the optical sensor includes an ambient light sensor and a proximity sensor. The ambient light sensor may adjust luminance of the display panel 12061 according to brightness of ambient light. The proximity sensor may turn off the display panel 12061 and/or backlight when the mobile terminal 1200 is moved to an ear. As a type of the motion sensor, an accelerometer sensor may detect an acceleration value in each direction (generally, three axes), and detect a value and a direction of gravity when the accelerometer sensor is static, and may be used in an application for recognizing a mobile terminal posture (such as screen switching between landscape and portrait modes, a related game, or magnetometer posture calibration), a function related to vibration recognition (such as a pedometer or a knock), and the like. The sensor 1205 may further include a fingerprint sensor, a pressure sensor, an iris sensor, a molecular sensor, a gyroscope, a barometer, a hygrometer, a thermometer, an infrared sensor, and the like. Details are not described herein.

The display unit 1206 is configured to display information entered by a user or information provided for a user. The display unit 1206 may include the display panel 12061. The display panel 12061 may be configured in a form of a liquid crystal display (Liquid Crystal Display, LCD), an organic light-emitting diode (Organic Light-Emitting Diode, OLED), or the like.

The user input unit 1207 may be configured to: receive digit or character information that is input, and generate key signal input related to user setting and function control of the mobile terminal. Specifically, the user input unit 1207 includes a touch panel 12071 and another input device 12072. The touch panel 12071 is also referred to as a touchscreen, and may collect a touch operation performed by a user on or near the touch panel 12071 (such as an operation performed by a user on the touch panel 12071 or near the touch panel 12071 by using any proper object or accessory, such as a finger or a stylus). The touch panel 12071 may include two parts: a touch detection apparatus and a touch controller. The touch detection apparatus detects a touch location of the user, detects a signal brought by the touch operation, and sends the signal to the touch controller. The touch controller receives touch information from the touch detection apparatus, converts the touch information into touch point coordinates, sends the touch point coordinates to the processor 1210, and receives and executes a command sent by the processor 1210. In addition, the touch panel 12071 may be implemented in various types such as a resistor, a capacitor, an infrared ray, or a surface acoustic wave. The user input unit 1207 may include another input device 12072 in addition to the touch panel 12071. Specifically, the another input device 12072 may include but is not limited to a physical keyboard, a functional button (such as a volume control button or a power on/off button), a trackball, a mouse, and a joystick. Details are not described herein.

Further, the touch panel 12071 may cover the display panel 12061. When detecting the touch operation on or near the touch panel 12071, the touch panel 12071 transmits the touch operation to the processor 1210 to determine a type of a touch event, and then the processor 1210 provides corresponding visual output on the display panel 12061 based on the type of the touch event. In FIG 12, although the touch panel 12071 and the display panel 12061 are used as two independent parts to implement input and output functions of the mobile terminal, in some embodiments, the touch panel 12071 and the display panel 12061 may be integrated to implement the input and output functions of the mobile terminal. Details are not described herein.

The interface unit 1208 is an interface for connecting an external apparatus with the mobile terminal 1200. For example, the external apparatus may include a wired or wireless headphone port, an external power supply (or a battery charger) port, a wired or wireless data port, a storage card port, a port used to connect to an apparatus having an identification module, an audio input/output (I/O) port, a video I/O port, and a headset port. The interface unit 1208 may be configured to receive input (for example, data information or power) from the external apparatus and transmit the received input to one or more elements in the mobile terminal 1200 or may be configured to transmit data between the mobile terminal 1200 and the external apparatus.

The memory 1209 may be configured to store a software program and various data. The memory 1209 may mainly include a program storage area and a data storage area. The program storage area may store an operating system, an application program required for at least one function (such as an audio playing function and an image playing function, etc.) etc. The data storage area may store data (such as audio data and a phone book, etc.) created according to use of the mobile phone. In addition, the memory 1209 may include a high speed random access memory, and may further include a non-volatile memory, such as at least one magnetic disk memory device, a flash memory device, or other non-volatile solid state memory devices.

The processor 1210 is a control center of the mobile terminal and is connected to all the parts of the entire mobile terminal by using various interfaces and lines, and performs various functions of the mobile terminal and data processing by running or executing the software program and/or module that are/is stored in the memory 1209 and by invoking data stored in the memory 1209, so as to perform overall monitoring on the mobile terminal. The processor 1210 may include one or more processing units. Optionally, an application processor and a modem processor may be integrated into the processor 1210. The application processor mainly processes an operating system, a user interface, an application program, and the like. The modem processor mainly processes wireless communications. It may be understood that, alternatively, the modem processor may not be integrated into the processor 1210.

The mobile terminal 1200 may further include the power supply 1211 (for example, a battery) that supplies power to each component. Optionally, the power supply 1211 may be logically connected to the processor 1210 by using a power management system, so as to implement functions such as charging management, discharging management, and power consumption management by using the power management system.

In addition, the mobile terminal 1200 includes some function modules that are not shown. Details are not described herein.

It should be noted that, in this specification, the terms "include", "comprise", or their any other variant is intended to cover a non-exclusive inclusion, so that a process, a method, an article, or an apparatus that includes a list of elements not only includes those elements but also includes other elements which are not expressly listed, or further includes elements inherent to such process, method, article, or apparatus. An element defined by "includes a ..." does not, without more constraints, preclude the presence of additional identical elements in the process, method, article, or apparatus that includes the element.

Based on the foregoing descriptions of the embodiments, a person skilled in the art may clearly understand that the method in the foregoing embodiment may be implemented by software in addition to a necessary universal hardware platform or by hardware only. In most circumstances, the former is a preferred implementation manner. Based on such an understanding, the technical solutions of the present disclosure essentially or the part contributing to the related art may be implemented in a form of a software product. The computer software product is stored in a storage medium (for example, a ROM/RAM, a floppy disk, or an optical disc), and includes several instructions for instructing a terminal (which may be a mobile phone, a server, an air conditioner, a network device, or the like) to perform the methods described in the embodiments of the present disclosure. The invention is defined by the appended claims.

## Claims

1. A mobile terminal (1), comprising a first camera module (11) and a second camera module (12) adjacent to the first camera module (11), wherein the first camera module (11) comprises a first image sensor (111), and the second camera module (12) comprises a second image sensor (121);
a first pixel array corresponding to the first image sensor (111) comprises a preset quantity of first pixel units arranged in a first predetermined manner, and the first pixel unit comprises a first pixel and a second pixel adjacent to the first pixel in location;
a second pixel array corresponding to the second image sensor (121) comprises a preset quantity of second pixel units arranged in a second predetermined manner, and the second pixel unit comprises the first pixel; and
the first pixel comprises a red subpixel, a green subpixel, and a blue subpixel, the second pixel comprises the green subpixel and an infrared subpixel, and at least one of the red subpixel and the blue subpixel, both the first pixel and the second pixel are full-pixel dual-core focus pixels, and each of the first pixel and the second pixel comprises four full-pixel dual-core focus subpixels.

2. The mobile terminal (1) according to claim 1, wherein
a location of the infrared subpixel in the second pixel is the same as a location of the red subpixel, the green subpixel, or the blue subpixel in the first pixel; or
a location of the infrared subpixel in the second pixel is the same as a location of a first combined subpixel in the first pixel, or the same as a location of a second combined subpixel in the first pixel, wherein
the first combined subpixel is a combination of 1/2 red subpixel and 1/2 green subpixel adjacent in location, and the second combined subpixel is a combination of 1/2 green subpixel and 1/2 blue subpixel adjacent in location.

3. The mobile terminal (1) according to claim 2, wherein
the first pixel unit comprises one second pixel and at least one first pixel.

4. The mobile terminal (1) according to claim 1, wherein
a location of 1/2 infrared subpixel in the second pixel is the same as a location of 1/2 red subpixel, 1/2 green subpixel, or 1/2 blue subpixel in the first pixel, and 1/2 infrared subpixel in two adjacent second pixels constitutes the infrared subpixel.

5. The mobile terminal (1) according to claim 4, wherein in the first pixel unit, a quantity of second pixels is two, and a quantity of first pixels is greater than zero.

6. The mobile terminal (1) according to claim 1, wherein
the red subpixel comprises a semiconductor layer, a metal layer, a photodiode, a red filter, and a micromirror stacked in sequence;
the green subpixel comprises a semiconductor layer, a metal layer, a photodiode, a green filter, and a micromirror stacked in sequence;
the blue subpixel comprises a semiconductor layer, a metal layer, a photodiode, a blue filter, and a micromirror stacked in sequence; and
the infrared subpixel comprises a semiconductor layer, a metal layer, a photodiode, an infrared filter, and a micromirror stacked in sequence.

7. The mobile terminal (1) according to claim 1, wherein the first camera module (11) and the second camera module (12) are connected through a synchronization module (14).

8. The mobile terminal (1) according to claim 1, further comprising:
an infrared emitting module (15) disposed on a periphery of the first camera module (11);
a power supply module (16) connected to the first camera module (11), the second camera module (12), and the infrared emitting module (15);
an image processor (17) connected to the first camera module (11) and the second camera module (12), wherein both the image processor (17) and the power supply module (16) are integrated into a mainboard of the mobile terminal (1), and the infrared emitting module (15) is connected to the mainboard of the mobile terminal (1); and
a display module (18) connected to the image processor (17).

9. The mobile terminal (1) according to claim 1, wherein the first camera module (11) further comprises:
a first lens module (112);
a first driving module (113) configured to drive the first lens module (112) to move; and
a first filtering module (114) disposed between the first lens module (112) and the first image sensor (111), wherein the first filtering module (114) can pass through an optical wavelength of 380 nm to 1100 nm.

10. The mobile terminal (1) according to claim 1, wherein the second camera module (12) further comprises:
a second lens module (122);
a second driving module (123) configured to drive the second lens module (122) to move; and
a second filtering module (124) disposed between the second lens module (122) and the second image sensor (121), wherein the second filtering module (124) can pass through an optical wavelength of 380 nm to 700 nm.

11. The mobile terminal (1) of claim 1, wherein both the first image sensor (111) and the second image sensor (121) are complementary metal-oxide-semiconductor, CMOS, image sensors, charge coupled device, CCD, image sensors, or quantum thin film image sensors.

12. An image photographing method, applied to the mobile terminal according to claim 1, wherein the method comprises:
obtaining (1001) depth of field information by using the first camera module and the second camera module of the mobile terminal;
obtaining (1002), according to the depth of field information, first image data collected by the first camera module and second image data collected by the second camera module, wherein the first image data and the second image data are same-frame data; and
generating (1003) a background blurred image through triangulation ranging according to the first image data and the second image data.

13. An image photographing method, applied to the mobile terminal according to claim 1, wherein the mobile terminal further comprises an infrared emitting module disposed on a periphery of the first camera module, and the method comprises:
emitting (1101) infrared light by using the infrared emitting module;
obtaining (1102) a distance between each infrared light reflection point on a to-be-photographed object and the first camera module according to infrared light reflected by the to-be-photographed object; and
obtaining (1103) stereoscopic information of the to-be-photographed object according to the distance between each infrared light reflection point on the to-be-photographed object and the first camera module.

14. The mobile terminal according to claim 1, further comprising a memory, a processor, and a computer program that is stored in the memory and that can run on the processor, wherein when the processor executes the computer program, the steps of the image photographing method according to either of claims 12 and 13 are performed.

15. A computer readable storage medium having a computer program stored thereon, wherein when the computer program is executed by the processor of the mobile terminal according to claim 14, the steps of the image photographing method according to either of claims 12 and 13 are performed.

## Patentansprüche

1. Mobiles Endgerät (1) mit einem ersten Kameramodul (11) und einem zweiten Kameramodul (12) neben dem ersten Kameramodul (11), wobei das erste Kameramodul (11) einen ersten Bildsensor (111) aufweist und das zweite Kameramodul (12) einen zweiten Bildsensor (121) aufweist;
wobei ein erstes Pixelarray, das dem ersten Bildsensor (111) entspricht, eine voreingestellte Menge von ersten Pixeleinheiten aufweist, die in einer ersten vorbestimmten Weise angeordnet sind, und die erste Pixeleinheit ein erstes Pixel und ein zweites Pixel, örtlich neben dem ersten Pixel, aufweist;
ein zweites Pixelarray, das dem zweiten Bildsensor (121) entspricht, eine voreingestellte Menge von zweiten Pixeleinheiten aufweist, die in einer zweiten vorbestimmten Weise angeordnet sind, und die zweite Pixeleinheit das erste Pixel aufweist; und
das erste Pixel ein rotes Subpixel, ein grünes Subpixel und ein blaues Subpixel aufweist, das zweite Pixel das grüne Subpixel und ein Infrarot-Subpixel und mindestens eines von dem roten Subpixel und dem blauen Subpixel aufweist, sowohl das erste Pixel als auch das zweite Pixel Vollpixel-Dual-Core-Fokuspixel sind und sowohl das erste Pixel als auch das zweite Pixel vier Vollpixel-Dual-Core-Fokus-Subpixel aufweist.

2. Mobiles Endgerät (1) nach Anspruch 1, wobei
eine Position des Infrarot-Subpixels in dem zweiten Pixel dieselbe ist wie eine Position des roten Subpixels, des grünen Subpixels oder des blauen Subpixels in dem ersten Pixel; oder
eine Position des Infrarot-Subpixels in dem zweiten Pixel derselbe ist wie eine Position eines ersten kombinierten Subpixels in dem ersten Pixel, oder dieselbe ist wie eine Position eines zweiten kombinierten Subpixels in dem ersten Pixel, wobei
das erste kombinierte Subpixel eine Kombination aus 1/2 rotem Subpixel und 1/2 grünem Subpixel ist, die positionsbenachbart sind, und das zweite kombinierte Subpixel eine Kombination aus 1/2 grünem Subpixel und 1/2 blauem Subpixel ist, die positionsbenachbart sind.

3. Mobiles Endgerät (1) nach Anspruch 2, wobei
die erste Pixeleinheit ein zweites Pixel und mindestens ein erstes Pixel aufweist.

4. Mobiles Endgerät (1) nach Anspruch 1, wobei
eine Position von 1/2 Infrarot-Subpixel in dem zweiten Pixel die gleiche ist wie eine Position von 1/2 rotem Subpixel, 1/2 grünem Subpixel oder 1/2 blauem Subpixel in dem ersten Pixel, und 1/2 Infrarot-Subpixel in zwei benachbarten zweiten Pixeln das Infrarot-Subpixel bildet.

5. Mobiles Endgerät (1) nach Anspruch 4, wobei in der ersten Pixeleinheit eine Anzahl von zweiten Pixeln zwei ist und eine Anzahl von ersten Pixeln größer als Null ist.

6. Mobiles Endgerät (1) nach Anspruch 1, wobei
das rote Subpixel eine Halbleiterschicht, eine Metallschicht, eine Fotodiode, einen Rotfilter und einen Mikrospiegel aufweist, die nacheinander gestapelt angeordnet sind;
das grüne Subpixel eine Halbleiterschicht, eine Metallschicht, eine Fotodiode, einen Grünfilter und einen Mikrospiegel aufweist, die nacheinander gestapelt angeordnet sind;
das blaue Subpixel eine Halbleiterschicht, eine Metallschicht, eine Fotodiode, einen Blaufilter und einen Mikrospiegel aufweist, die nacheinander gestapelt sind; und
das Infrarot-Subpixel eine Halbleiterschicht, eine Metallschicht, eine Fotodiode, einen Infrarotfilter und einen Mikrospiegel aufweist, die nacheinander gestapelt angeordnet sind.

7. Mobiles Endgerät (1) nach Anspruch 1, wobei das erste Kameramodul (11) und das zweite Kameramodul (12) über ein Synchronisationsmodul (14) verbunden sind.

8. Mobiles Endgerät (1) nach Anspruch 1, ferner aufweisend:
ein infrarotemittierendes Modul (15), das an einer Peripherie des ersten Kameramoduls (11) angeordnet ist;
ein Stromversorgungsmodul (16), das mit dem ersten Kameramodul (11), dem zweiten Kameramodul (12) und dem infrarotemittierendes Modul (15) verbunden ist;
einen Bildprozessor (17), der mit dem ersten Kameramodul (11) und dem zweiten Kameramodul (12) verbunden ist, wobei sowohl der Bildprozessor (17) als auch das Stromversorgungsmodul (16) in eine Hauptplatine des mobilen Endgeräts (1) integriert sind, und das infrarotemittierende Modul (15) mit der Hauptplatine des mobilen Endgeräts (1) verbunden ist; und
ein Anzeigemodul (18), das mit dem Bildprozessor (17) verbunden ist.

9. Mobiles Endgerät (1) nach Anspruch 1, wobei das erste Kameramodul (11) ferner aufweist:
ein erstes Linsenmodul (112);
ein erstes Antriebsmodul (113), das derart konfiguriert ist, dass es das erste Linsenmodul (112) in Bewegung versetzt; und
ein erstes Filtermodul (114), das zwischen dem ersten Linsenmodul (112) und dem ersten Bildsensor (111) angeordnet ist, wobei das erste Filtermodul (114) eine optische Wellenlänge von 380 nm bis 1100 nm durchlässt.

10. Mobiles Endgerät (1) nach Anspruch 1, wobei das zweite Kameramodul (12) ferner aufweist:
ein zweites Linsenmodul (122);
ein zweites Antriebsmodul (123), das derart konfiguriert ist, dass es das zweite Linsenmodul (122) zur Bewegung antreibt; und
ein zweites Filtermodul (124), das zwischen dem zweiten Linsenmodul (122) und dem zweiten Bildsensor (121) angeordnet ist, wobei das zweite Filtermodul (124) eine optische Wellenlänge von 380 nm bis 700 nm durchlässt.

11. Mobiles Endgerät (1) nach Anspruch 1, wobei sowohl der erste Bildsensor (111) als auch der zweite Bildsensor (121) komplementäre Metall-Oxid-Halbleiter-, CMOS-, Bildsensoren, ladungsgekoppelte Vorrichtungs-, CCD-, Bildsensoren oder Quanten-Dünnschicht-Bildsensoren sind.

12. Verfahren zum Fotografieren von Bildern, das auf das mobile Endgerät nach Anspruch 1 angewendet wird, wobei das Verfahren die folgenden Schritte umfasst:
Erhalten (1001) von Schärfentiefeninformation durch Verwendung des ersten Kameramoduls und des zweiten Kameramoduls des mobilen Endgeräts;
Erhalten (1002) von ersten Bilddaten, die von dem ersten Kameramodul gesammelt wurden, und von zweiten Bilddaten, die von dem zweiten Kameramodul gesammelt wurden, gemäß der Schärfentiefeninformation, wobei die ersten Bilddaten und die zweiten Bilddaten Daten desselben Einzelbildes sind; und
Erzeugen (1003) eines unscharfen Hintergrundbildes durch Triangulation gemäß den ersten Bilddaten und den zweiten Bilddaten.

13. Verfahren zum Fotografieren von Bildern, das auf das mobile Endgerät nach Anspruch 1 angewendet wird, wobei das mobile Endgerät ferner ein infrarotemittierendes Modul aufweist, das an einer Peripherie des ersten Kameramoduls angeordnet ist, und das Verfahren die folgenden Schritte umfasst:
Senden (1101) von Infrarotlicht unter Verwendung des infrarotemittierenden Moduls;
Erhalten (1102) eines Abstands zwischen jedem Infrarotlicht-Reflexionspunkt auf einem zu fotografierenden Objekt und dem ersten Kameramodul gemäß dem zu fotografierenden Objekt reflektierten Infrarotlicht; und
Erhalten (1103) von stereoskopischen Informationen des zu fotografierenden Objekts gemäß dem Abstand zwischen jedem Infrarotlicht-Reflexionspunkt auf dem zu fotografierenden Objekt und dem ersten Kameramodul.

14. Mobiles Endgerät nach Anspruch 1, das ferner einen Speicher, einen Prozessor und ein Computerprogramm aufweist, das in dem Speicher gespeichert ist und auf dem Prozessor ausführbar ist, wobei, wenn der Prozessor das Computerprogramm ausführt, die Schritte des Verfahrens zum Fotografieren von Bildern, nach einem der Ansprüche 12 und 13 durchgeführt werden.

15. Computerlesbares Speichermedium mit einem darauf gespeicherten Computerprogramm, wobei wenn das Computerprogramm durch den Prozessor des mobilen Endgeräts nach Anspruch 14 ausgeführt wird, die Schritte des Verfahrens zum Fotografieren von Bildern nach einem der Ansprüche 12 und 13 durchgeführt werden.

## Revendications

1. Terminal mobile (1), comprenant un premier module caméra (11) et un second module caméra (12) adjacent au premier module caméra (11), dans lequel le premier module caméra (11) comprend un premier capteur d'image (111), et le second module caméra (12) comprend un second capteur d'image (121) ;
un premier réseau de pixels correspondant au premier capteur d'image (111) comprend une quantité prédéfinie de premières unités de pixels agencées d'une première manière prédéterminée, et la première unité de pixels comprend un premier pixel et un second pixel adjacent au premier pixel en emplacement ;
un second réseau de pixels correspondant au second capteur d'image (121) comprend une quantité prédéfinie de secondes unités de pixels agencées d'une seconde manière prédéterminée, et la seconde unité de pixels comprend le premier pixel ; et
le premier pixel comprend un sous-pixel rouge, un sous-pixel vert et un sous-pixel bleu, le second pixel comprend le sous-pixel vert et un sous-pixel infrarouge, et au moins un parmi le sous-pixel rouge et le sous-pixel bleu, à la fois le premier pixel et le second pixel sont des pixels de mise au point double coeur plein pixel, et chacun du premier pixel et du second pixel comprend quatre sous-pixels de mise au point double coeur plein pixel.

2. Terminal mobile (1) selon la revendication 1, dans lequel
un emplacement du sous-pixel infrarouge dans le second pixel est le même qu'un emplacement du sous-pixel rouge, du sous-pixel vert ou du sous-pixel bleu dans le premier pixel ; ou
un emplacement du sous-pixel infrarouge dans le second pixel est le même qu'un emplacement d'un premier sous-pixel combiné dans le premier pixel, ou le même qu'un emplacement d'un second sous-pixel combiné dans le premier pixel, dans lequel
le premier sous-pixel combiné est une combinaison de 1/2 sous-pixel rouge et 1/2 sous-pixel vert adjacents en emplacement, et le second sous-pixel combiné est une combinaison de 1/2 sous-pixel vert et 1/2 sous-pixel bleu adjacents en emplacement.

3. Terminal mobile (1) selon la revendication 2, dans lequel la première unité de pixels comprend un second pixel et au moins un premier pixel.

4. Terminal mobile (1) selon la revendication 1, dans lequel
un emplacement de 1/2 sous-pixel infrarouge dans le second pixel est le même qu'un emplacement de 1/2 sous-pixel rouge, 1/2 sous-pixel vert ou 1/2 sous-pixel bleu dans le premier pixel, et 1/2 sous-pixel infrarouge dans deux seconds pixels adjacents constitue le sous-pixel infrarouge.

5. Terminal mobile (1) selon la revendication 4, dans lequel, dans la première unité de pixels, une quantité de seconds pixels est de deux, et une quantité de premiers pixels est supérieure à zéro.

6. Terminal mobile (1) selon la revendication 1, dans lequel
le sous-pixel rouge comprend une couche semi-conductrice, une couche métallique, une photodiode, un filtre rouge et un micromiroir empilés en séquence ;
le sous-pixel vert comprend une couche semi-conductrice, une couche métallique, une photodiode, un filtre vert et un micromiroir empilés en séquence ;
le sous-pixel bleu comprend une couche semi-conductrice, une couche métallique, une photodiode, un filtre bleu et un micromiroir empilés en séquence ; et
le sous-pixel infrarouge comprend une couche semi-conductrice, une couche métallique, une photodiode, un filtre infrarouge et un micromiroir empilés en séquence.

7. Terminal mobile (1) selon la revendication 1, dans lequel le premier module caméra (11) et le second module caméra (12) sont connectés par le biais d'un module de synchronisation (14).

8. Terminal mobile (1) selon la revendication 1, comprenant en outre :
un module d'émission infrarouge (15) disposé sur une périphérie du premier module caméra (11) ;
un module d'alimentation électrique (16) connecté au premier module caméra (11), au second module caméra (12) et au module d'émission infrarouge (15) ;
un processeur d'image (17) connecté au premier module caméra (11) et au second module caméra (12), dans lequel le processeur d'image (17) et le module d'alimentation électrique (16) sont tous deux intégrés dans une carte mère du terminal mobile (1), et le module d'émission infrarouge (15) est connecté à la carte mère du terminal mobile (1) ; et
un module d'affichage (18) connecté au processeur d'image (17).

9. Terminal mobile (1) selon la revendication 1, dans lequel le premier module caméra (11) comprend en outre :
un premier module lentille (112) ;
un premier module d'entraînement (113) configuré pour amener le premier module lentille (112) à se déplacer ; et
un premier module de filtrage (114) disposé entre le premier module lentille (112) et le premier capteur d'image (111), dans lequel le premier module de filtrage (114) peut traverser une longueur d'onde optique de 380 nm à 1100 nm.

10. Terminal mobile (1) selon la revendication 1, dans lequel le second module caméra (12) comprend en outre :
un second module lentille (122) ;
un second module d'entraînement (123) configuré pour amener le second module lentille (122) à se déplacer ; et
un second module de filtrage (124) disposé entre le second module lentille (122) et le second capteur d'image (121), dans lequel le second module de filtrage (124) peut traverser une longueur d'onde optique de 380 nm à 700 nm.

11. Terminal mobile (1) selon la revendication 1, dans lequel le premier capteur d'image (111) et le second capteur d'image (121) sont tous deux des capteurs d'image à métal-oxyde-semi-conducteur complémentaire, CMOS, des capteurs d'image à dispositif à couplage de charge, DCC, ou des capteurs d'image à film mince quantique.

12. Procédé de photographie d'image, appliqué au terminal mobile selon la revendication 1, dans lequel le procédé comprend :
l'obtention (1001) d'informations de profondeur de champ à l'aide du premier module caméra et du second module caméra du terminal mobile ;
l'obtention (1002), en fonction des informations de profondeur de champ, de premières données d'image collectées par le premier module caméra et de secondes données d'image collectées par le second module caméra, dans lequel les premières données d'image et les secondes données d'image sont des données de même trame ; et
la génération (1003) d'une image d'arrière-plan floue par mesure de distances par triangulation en fonction des premières données d'image et des secondes données d'image.

13. Procédé de photographie d'image, appliqué au terminal mobile selon la revendication 1, dans lequel le terminal mobile comprend en outre un module d'émission infrarouge disposé sur une périphérie du premier module caméra, et le procédé comprend :
l'émission (1101) d'une lumière infrarouge à l'aide du module d'émission infrarouge ;
l'obtention (1102) d'une distance entre chaque point de réflexion de lumière infrarouge sur un objet à photographier et le premier module caméra en fonction de la lumière infrarouge réfléchie par l'objet à photographier ; et
l'obtention (1103) d'informations stéréoscopiques de l'objet à photographier en fonction de la distance entre chaque point de réflexion de lumière infrarouge sur l'objet à photographier et le premier module caméra.

14. Terminal mobile selon la revendication 1, comprenant en outre une mémoire, un processeur et un programme informatique qui est stocké dans la mémoire et qui peut s'exécuter sur le processeur, dans lequel, lorsque le processeur exécute le programme informatique, les étapes du procédé de photographie d'image selon l'une ou l'autre des revendications 12 et 13 sont effectuées.

15. Support de stockage lisible par ordinateur sur lequel est stocké un programme informatique, dans lequel, lorsque le programme informatique est exécuté par le processeur du terminal mobile selon la revendication 14, les étapes du procédé de photographie d'image selon l'une ou l'autre des revendications 12 et 13 sont effectuées.
